(19)

Europäisches Patentamt
European Patent Office
Office européen des brevets

(11) **EP 1 772 442 B1**

(12) **EUROPEAN PATENT SPECIFICATION**

(45) Date of publication and mention of the grant of the patent:
**05.05.2010 Bulletin 2010/18**

(51) Int Cl.:
*C04B 35/493* (2006.01)    *H01L 41/083* (2006.01)
*H01L 41/187* (2006.01)

(21) Application number: **06020835.2**

(22) Date of filing: **04.10.2006**

(54) **Piezoelectric ceramic composition and laminated piezoelectric element**

Piezoelektrische keramische Zusammensetzung und ein laminiertes piezoelektrisches Element

Composition d'une céramique piézoélectrique et un elément piézoélectrique laminé

(84) Designated Contracting States:
**DE**

(30) Priority: **04.10.2005 JP 2005291761**
**05.10.2005 JP 2005292637**
**21.12.2005 JP 2005367444**
**02.03.2006 JP 2006056767**
**03.03.2006 JP 2006057079**
**08.03.2006 JP 2006063243**

(43) Date of publication of application:
**11.04.2007 Bulletin 2007/15**

(60) Divisional application:
**10150516.2**

(73) Proprietor: **TDK Corporation**
**Tokyo 103-8272 (JP)**

(72) Inventors:
• **Iezumi, Kumiko**
  **Tokyo 103-8272 (JP)**
• **Yamazaki, Junichi**
  **Tokyo 103-8272 (JP)**
• **Tsukada, Takeo**
  **Tokyo 103-8272 (JP)**
• **Sakamoto, Norimasa**
  **Tokyo 103-8272 (JP)**
• **Sogabe, Tomohiro**
  **Tokyo 103-8272 (JP)**
• **Nanao, Masaru**
  **Tokyo 103-8272 (JP)**

(74) Representative: **HOFFMANN EITLE**
**Patent- und Rechtsanwälte**
**Arabellastrasse 4**
**81925 München (DE)**

(56) References cited:
**EP-A- 1 702 905**        **EP-A1- 1 382 587**
**EP-A2- 1 367 036**        **WO-A2-01/45138**
**JP-A- 2000 007 431**      **JP-A- 2001 328 864**
**JP-A- 2002 299 710**      **JP-A- 2004 137 106**
**US-A- 6 123 867**          **US-A1- 2003 168 624**
**US-A1- 2005 035 686**

• **DATABASE WPI Week 197431 Derwent Publications Ltd., London, GB; AN 1974-55858V XP002410196 -& JP 49 028900 A (MATSUSHITA ELEC IND CO LTD) 14 March 1974 (1974-03-14)**

**Description**

BACKGROUND OF THE INVENTION

Field of the Invention

The present invention relates to a piezoelectric ceramic composition suitable for piezoelectric layers in various piezoelectric elements in devices such as an actuator, piezoelectric buzzer, a sound component and a sensor, in particular, to a piezoelectric ceramic composition also suitable for piezoelectric layers in a laminated piezoelectric element using Cu for internal electrodes and a laminated piezoelectric element using the composition concerned.

Description of the Related Art

Piezoelectric ceramic compositions to be used in piezoelectric elements are required to be large in piezoelectric properties, in particular, in piezoelectric strain constant. As piezoelectric ceramic compositions satisfying such properties, there have been developed, for example, a ternary piezoelectric ceramic composition containing lead titanate ($PbTiO_3$), lead zirconate ($PbZrO_3$) and lead zincate niobate [$Pb(Zn_{1/3}Nb_{2/3})O_3$], a piezoelectric ceramic composition in which the Pb in the above-mentioned ternary piezoelectric ceramic composition is partially substituted with Sr, Ba, Ca or the like, and other piezoelectric ceramic compositions.

However, these conventional piezoelectric ceramic compositions require sintering at relatively high temperatures exceeding 1200°C, and undergo sintering in an oxidative atmosphere; consequently, for example, in laminated piezoelectric elements in which internal electrodes are simultaneously sintered, it has been necessary to use noble metals (such as Pt and Pd) that are high in melting point and are not oxidized even when sintered in an oxidative atmosphere. As a result, the increase in cost is caused to offer an obstacle to price reduction of manufactured laminated piezoelectric elements.

Under these circumstances, the present applicant has proposed to enable low temperature sintering by adding a first additive containing at least one selected from Fe, Co, Ni and Cu and a second additive containing at least one selected from Sb, Nb and Ta to the above-mentioned ternary piezoelectric ceramic compositions, and consequently to make low price materials such as a Ag-Pd alloy usable for internal electrodes (see Japanese Patent Laid-Open No. 2004-137106).

The invention of Japanese Patent Laid-Open No. 2004-137106 is such that there is realized a piezoelectric ceramic composition having a high piezoelectric strain constant, and being densified without impairing various piezoelectric properties and being increased in mechanical strength even when sintered at low temperatures, by adding the first additive containing at least one selected from Fe, Co, Ni and Cu, and the second additive containing at least one selected from Sb, Nb and Ta in the above-mentioned ternary piezoelectric ceramic composition and in the piezoelectric ceramic composition in which Pb in the above-mentioned ternary piezoelectric ceramic composition is partially substituted with Sr, Ba, Ca or the like, and there is also provided a piezoelectric element having piezoelectric layers formed by using the thus realized piezoelectric ceramic composition.

SUMMARY OF THE INVENTION

When internal electrodes are formed with a lower price metal (such as Cu), there occurs a disadvantage such that sintering in an oxidative atmosphere (for example, in air) oxidizes the internal electrodes to impair the conductivity even in a case where the sintering is carried out at a low temperature. To overcome such a disadvantage, the sintering is required to be carried out in a reductive atmosphere having a low oxygen partial pressure (for example, an oxygen partial pressure of the order of $1 \times 10^{-10}$ to $1 \times 10^{-6}$ atm). However, such sintering in a reductive atmosphere has encountered a problem that the piezoelectric properties are impaired although the oxidation of the internal electrodes themselves can be prevented.

Such sintering in a reductive atmosphere abundantly generates oxygen vacancies in the crystal of a piezoelectric ceramic composition because of the extreme scarcity of oxygen in the atmosphere, as compared to sintering in air. The presence of such oxygen vacancies degrades the electric resistance of the piezoelectric ceramic composition at high temperatures (for example, 150°C). A temperature region about 150°C is sometimes included in a specified operating temperature range of a product, and accordingly, the degradation of the electric resistance of a piezoelectric ceramic composition seriously affects the reliability of the product.

In these years, demand for size reduction and sophistication of various products leads to demand for size reduction and sophistication for actuators to be used in such products. Size reduction of an actuator element while preserving the displacement magnitude thereof necessitates a piezoelectric ceramic composition that has further higher piezoelectric properties. In particular, a development challenge is to search out a piezoelectric ceramic composition that attains high piezoelectric properties even by low temperature sintering.

Accordingly, an object of the present invention is to provide a piezoelectric ceramic composition that does not degrade the piezoelectric properties even when Cu is used as a conductive material for internal electrodes, and further even when low temperature sintering is carried out.

Another object of the present invention is to provide a piezoelectric ceramic composition that can inhibit the degradation of the electric resistance to be caused by the oxygen vacancies due to sintering at low temperatures and in a reductive atmosphere.

Yet another object of the present invention is to provide a laminated piezoelectric element using such a piezoelectric ceramic composition.

The present inventors have investigated the cause for the degradation of the piezoelectric properties in a case where Cu is used as a conductive material for internal electrodes, and have found that Cu diffuses from the internal electrodes into the piezoelectric layers and the grain growth in the piezoelectric layers is inhibited. Consequently, the present inventors have interpreted that the diffusion of Cu into the piezoelectric layers and the insufficient grain growth cause the piezoelectric property degradation.

However, there has been obtained a finding that the presence of Cu in the piezoelectric layers overcomes the electric resistance degradation at high temperatures. On the other hand, a rare earth element as an additive is effective against the degradation of the piezoelectric properties. Accordingly, the presence of Cu and the concomitant inclusion of the other additive make it possible to obtain a piezoelectric ceramic composition excellent in electric resistance at high temperatures and in piezoelectric properties.

Consequently, the present invention provides a piezoelectric ceramic composition comprising:

(i) as a main constituent, thereof a composite oxide represented by the formula

$$(Pb_{a-b}Me_b) [(Zn_{1/3}Nb_{2/3})_x Ti_y Zr_z]O_3$$

wherein
$0.96 \leq a \leq 1.03$,
$0.005 \leq b \leq 0.08$,
$0.05 \leq x \leq 0.15$,
$0.25 \leq y \leq 0.5$,
$0.35 \leq z \leq 0.6$,
$x + y + z = 1$, and
Me is at least one of Sr, Ca and Ba;

(ii) more than 0 to 0.8 wt.-%, in terms of oxide and in relation to the composite oxide (i), of a rare earth metal element as a first additive; and

(iii) more than 0 to 3.0 wt.-%, in terms of CuO and in relation to the composite oxide (i), of $CuO_\alpha$ ($\alpha \geq 0$) as a second additive.

The piezoelectric ceramic composition of the present invention preferably contains more than 0 to 1.0 wt.-%, in terms of oxide, of at least one of Ta, Sb, Nb and W as a third additive.

Further, the present invention provides a laminated piezoelectric element comprising:

(a) a plurality of piezoelectric layers comprising the piezoelectric ceramic composition as defined above; and

(b) a plurality of internal electrode layers formed between said piezoelectric layers and comprising Cu as a conductive material.

The present laminated piezoelectric element has as one of its features the fact that the piezoelectric layers contain more than 0 to 3.0 wt.-%, in terms of CuO and in relation to the composite oxide (i), of $CuO_\alpha$ ($\alpha \geq 0$). The $CuO_\alpha$ ($\alpha \geq 0$) in the piezoelectric layers can be formed by diffusing $CuO_\alpha$ ($\alpha \geq 0$) from the internal electrode layers or by adding $CuO_\alpha$ ($\alpha \geq 0$) into the piezoelectric layers.

Accordingly, the present invention further provides a method of producing a laminated piezoelectric element, comprising the steps of laminating with each other

(a) piezoelectric layer precursors comprising a piezoelectric ceramic composition comprising:

(i) as a main constituent thereof a composite oxide represented by the formula

$$(Pb_{a-b}Me_b)[(Zn_{1/3}Nb_{2/3})_xTi_yZr_z]O_3$$

wherein
$0.96 \leq a \leq 1.03$,
$0.005 \leq b \leq 0.08$,
$0.05 \leq x \leq 0.15$,
$0.25 \leq y \leq 0.5$,
$0.35 \leq z \leq 0.6$,
$x + y + z = 1$, and
Me is at least one of Sr, Ca and Ba;

(ii) more than 0 to 0.8 wt.-%, in terms of oxide and in relation to the composite oxide (i), of a rare earth metal element as a first additive; and

(iii) optionally $CuO_\alpha$ ($\alpha \geq 0$) as a second additive, and

(b) internal electrode precursors comprising Cu;

and sintering in a reductive atmosphere to diffuse the Cu contained in the internal electrode precursors into the piezoelectric layers to obtain a laminate, wherein the composition of the piezoelectric layers comprises the composite oxide (i) and the rare earth metal element (ii) as defined above, and

(iii) more than 0 to 3.0 wt.-%, in terms of CuO and in relation to the composite oxide (i), of $Cuo_\alpha$ ($\alpha \geq 0$) as a second additive.

In the present production method the piezoelectric ceramic composition preferably further comprises 0 to 1.0 wt.-%, in terms of oxide, of at least one of Ta, Sb, Nb and W as a third additive.

Also, in the present production method the sintering step in a reductive atmosphere can be conducted at a sintering temperature of 800-1,200°C under an oxygen partial pressure of $1.013 \times 10^{-5}$ to $1.013 \times 10^{-1}$ Pa ($10^{-10}$ to $10^{-6}$ atm.), and these conditions allow the diffusion of the Cu contained in the internal electrode precursors into the piezoelectric layers.

As described above, according to the present invention, even when a low-price metal material, namely, Cu is used as a conductive material for the internal electrodes, it is possible to provide a piezoelectric ceramic composition high in piezoelectric properties such as the electromechanical coupling coefficient kr (%). Consequently, according to the present invention, it is possible to provide a laminated piezoelectric element that is excellent in piezoelectric properties although low in price. In particular, the present invention can attain a specific advantageous effect that the diffusion of Cu into the piezoelectric layers improves the piezoelectric properties.

Further, the present invention provides a piezoelectric ceramic composition that can inhibit the electric resistance degradation caused by the oxygen vacancies due to sintering at a low temperature in a reductive atmosphere.

BRIEF DESCRIPTION OF THE DRAWINGS

FIG. 1 is a view illustrating a construction example of a laminated piezoelectric element in an embodiment of the present invention;

FIG. 2 is a flow chart showing production procedures of the laminated piezoelectric element in an embodiment of the present invention;

FIG. 3 shows a TEM image and EDS point analysis results of a piezoelectric layer in the vicinity of an internal electrode layer in a laminated piezoelectric element obtained by using Cu in the internal electrode layer;

FIG. 4 is a table showing the compositions, and the measurement results of the high temperature load life and the piezoelectric property in Example 1;

FIG. 5 is a table showing the content of Eu, and the measurement results of the high temperature load life and the piezoelectric property when Eu was used as a rare earth metal element in Example 2;

FIG. 6 is a table showing the content of Y, and the measurement results of the high temperature load life and the piezoelectric property when Y was used as a rare earth metal element in Example 2;

FIG. 7 is a table showing the content of Gd, and the measurement results of the high temperature load life and the piezoelectric property when Gd was used as a rare earth metal element in Example 2;

FIG. 8 is a table showing the content of La, and the measurement results of the high temperature load life and the piezoelectric property when La was used as a rare earth metal element in Example 2;

FIG. 9 is a table showing the content of Yb, and the measurement results of the high temperature load life and the piezoelectric property when Yb was used as a rare earth metal element in Example 2;

FIG. 10 is a table showing the content of Nd, and the measurement results of the high temperature load life and the piezoelectric property when Nd was used as a rare earth metal element in Example 2;

FIG. 11 is a table showing the content of Dy, and the measurement results of the high temperature load life and the piezoelectric property when Dy was used as a rare earth metal element in Example 2;

FIG. 12 is a table showing the content of Ho, and the measurement results of the high temperature load life and the piezoelectric property when Ho was used as a rare earth metal element in Example 2;

FIG. 13 is a table showing the content of Tb, and the measurement results of the high temperature load life and the piezoelectric property when Tb was used as a rare earth metal element in Example 2;

FIG. 14 is a table showing the content of Er, and the measurement results of the high temperature load life and the piezoelectric property when Er was used as a rare earth metal element in Example 2;

FIG. 15 is a table showing the compositions, and the measurement results of the high temperature load life and the piezoelectric property in Example 3;

FIG. 16 is a table showing the compositions, and the measurement results of the high temperature load life and the piezoelectric property in Example 4;

FIG. 17 is a table showing the compositions, and the measurement results of the high temperature load life and the piezoelectric property in Example 5;

FIG. 18 is a table showing the compositions, and the measurement results of the high temperature load life and the piezoelectric property in Example 6;

FIG. 19 is a table showing the compositions, and the measurement results of the high temperature load life and the piezoelectric property in Example 7;

FIG. 20 is a table showing the forms, and the measurement results of the high temperature load life and the piezoelectric property in Example 8;

FIG. 21 is an EPMA photograph of a section of a piezoelectric layer of a laminated piezoelectric element prepared in Example 8;

## DETAILED DESCRIPTION OF THE PREFERRED EMBODIMENTS

Detailed description will be made below on the present invention on the basis of the embodiments shown in the accompanying drawings.

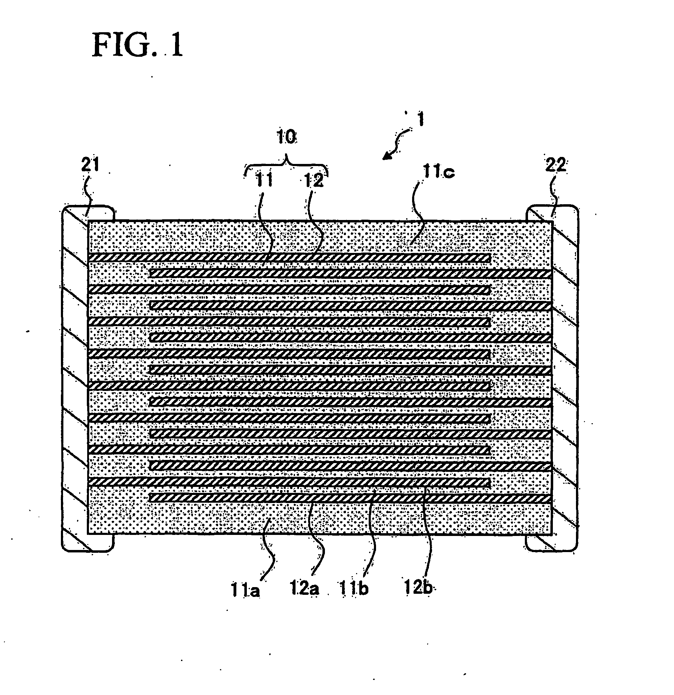

FIG. 1 is a sectional view illustrating a construction example of a laminated piezoelectric element 1 obtained by the present invention. FIG. 1 shows one example, and needless to say, the present invention is not limited to the laminated piezoelectric element 1 shown in FIG. 1. The laminated piezoelectric element 1 has a laminate 10 in which a plurality of piezoelectric layers 11 and a plurality of internal electrode layers 12 are alternately laminated with each other. The thickness of one piezoelectric layer 11 is set at, for example, 1 to 200 $\mu$m, preferably at 20 to 150 $\mu$m, and more preferably at 50 to 100 $\mu$m. The lamination number of the piezoelectric layers 11 is determined according to the targeted displacement magnitude.

The piezoelectric ceramic composition forming-the piezoelectric layers 11 contains as a main constituent a composite oxide that contains Pb, Ti and Zr as the constituent elements. Examples of the composite oxide include a ternary composite oxide constituted with lead titanate ($PbTiO_3$), lead zirconate ($PbZrO_3$) and lead zincate niobate [$Pb(Zn_{1/3}Nb_{2/3})O_3$], and a composite oxide in which the Pb contained in the above-mentioned ternary composite oxide is partially substituted with at least one of Sr, Ba and Ca.

The specific compositions of the composite oxides are represented by the following formula, wherein the composition of the oxygen is derived stoichiometrically; in the actual compositions, deviations from the stoichiometric compositions are allowed.

$$(Pb_{a-b}Me_b)\ [(Zn_{1/3}Nb_{2/3})_xTi_yZr_z]O_3 \qquad (2)$$

wherein $0.96 \leq a \leq 1.03$, $0,005 < b \leq 0.1$, $0.05 \leq x \leq 0.15$, $0.25 \leq y \leq 0.5$, $0.35 \leq z \leq 0.6$, and $x + y + z = 1$, Me representing at least one selected from Sr, Ca and Ba.

The above-mentioned composite oxide has a so-called perovskite structure, wherein Pb and the substitutional element Me in formula (2) are located at the so-called A site in the perovskite structure, and Zn, Nb, Ti and Zr are located at the so-called B site in the perovskite structure.

In each of the composite oxides represented by above formula (2), the A-site element ratio (molar ratio) "a" satisfies the relation that $0.96 \leq a \leq 1.03$ with the B-site molar ratio assumed to be 1. If the A-site element ratio "a" is less than 0.96, sintering at low temperatures may become difficult. If the A-site element ratio "a" exceeds 1.03, the density of the piezoelectric ceramic to be obtained may be degraded, which may result in poor piezoelectric properties and a lower mechanical strength. The A-site element ratio "a" more preferably satisfies the relation that $0.97 \leq a \leq 1.02$, and furthermore preferably $0.98 \leq a \leq 1.01$.

In the composite oxide represented by above formula (2), Pb is partially substituted with the substitutional element Me (Sr, Ca, Ba), and the piezoelectric strain constant can thereby be made larger. However, when the substitution amount b of the substitutional element Me becomes too large, the piezoelectric strain constant becomes smaller and the mechanical strength is also degraded. The Curie temperature also tends to be decreased with the increase of the substitution amount b. Consequently, the substitution amount b of the substitutional element Me is set to satisfy $0.005 \leq b \leq 0.08$, and preferably $0.007 \leq b \leq 0.05$.

Among the B-site elements, the ratio (molar ratio) x of Zn and Nb is set to satisfy $0.05 \leq x \leq 0.15$. The ratio x affects the sintering temperature. If the value of x is less than 0.05, the effect of lowering the sintering temperature may be insufficient. If the value of x exceeds 0.15, the sinterability is affected by such a x value, leading to a fear that the piezoelectric strain constant becomes small and the mechanical strength is degraded. The ratio x of Zn and Nb preferably satisfies $0.07 \leq x \leq 0.13$ and preferably $0.08 \leq x \leq 0.12$.

Among the ratios of the B-site elements, the ranges for the ratio y (molar ratio) of Ti and the ratio z (molar ratio) of Zr are set from the viewpoint of the piezoelectric properties. Specifically, the ratio y of Ti satisfies $0.25 \leq y \leq 0.5$, and the ratio z of Zr satisfies $0.35 \leq z \leq 0.6$. By setting these ratios to fall within the above-mentioned ranges, there can be obtained a large piezoelectric strain constant in the vicinity of the morphotropic phase boundary (MPB). The ratio y of Ti preferably satisfies $0.3 \leq y \leq 0.48$, and more preferably $0.4 \leq y \leq 0.46$. The ratio z of Zr preferably satisfies $0.37 \leq z \leq 0.55$, and more preferably $0.4 \leq z \leq 0.5$.

The above descriptions give the fundamental structure of the laminated piezoelectric element 1 of the present invention.

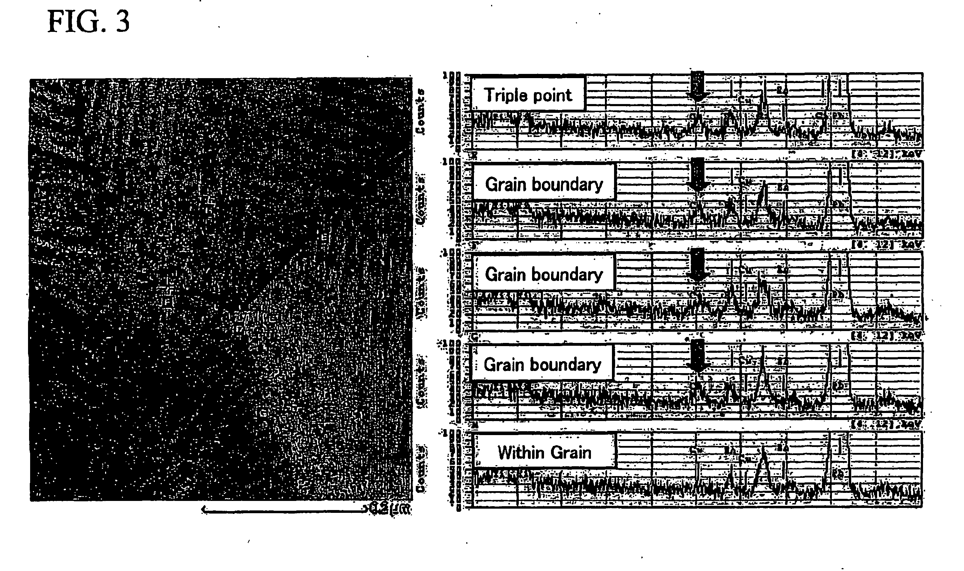

A laminated piezoelectric element 1 has been prepared by using Cu for the internal electrode layers 12, and the piezoelectric layers 11 in the vicinity of the internal electrode layers 12 have been subjected to an analysis based on TEM-EDS (field-emission type transmission electron microscope with energy dispersive X-ray spectroscopy). FIG. 3 shows a TEM image and point analysis results based on EDS. Cu is present at the triple points and the grain boundaries in the piezoelectric layers 11, and thus, it has been found that Cu diffuses from the internal electrode layers 12 in the sintering process. The Cu is present as $CuO_\alpha$ ($\alpha \geq 0$) in the piezoelectric layers 11. When $CuO_\alpha$ ($\alpha \geq 0$) is present as described above in the piezoelectric layers 11, the electric resistance degradation at high temperatures is inhibited and the high temperature load life is improved. However, if the content of $CuO_\alpha$ ($\alpha \geq 0$) becomes too large, the electromechanical coupling coefficient kr (%) may be decreased. Consequently, the content of $CuO_\alpha$ ($\alpha \geq 0$) is 3.0% by mass or less (not inclusive of 0). When the content of $CuO_\alpha$ ($\alpha \geq 0$) exceeds 3.0% by mass, the electromechanical coupling coefficient kr (%) may become 50 or less. The content of $CuO_\alpha$ ($\alpha \geq 0$) is preferably 0.01 to 3.0% by mass. Here, examples of $CuO_\alpha$ ($\alpha \geq 0$) may include the Cu oxides having arbitrary oxidation states such as $Cu_2O$ and CuO, and Cu($\alpha = 0$); two or more of these $CuO_\alpha$ ($\alpha \geq 0$) species may be contained.

The $CuO_\alpha$ ($\alpha \geq 0$) contained in the piezoelectric layers 11 may be generated by the diffusion of the Cu contained in the internal electrode layers 12 into the piezoelectric layers 11, or may be contained by adding $CuO_\alpha$ to the piezoelectric layers 11 at the time of preparing the raw material composition thereof. In the present invention, it is essential that the piezoelectric layers 11 contain Cu, but the present invention is indifferent about the addition process and the form of occurrence of Cu.

Here, description will be made on the experiment for identifying the effect due to the diffusion of Cu into the piezoelectric layers 11.

A piezoelectric ceramic composition has been prepared as follows. First, as the raw materials for the main constituent, a PbO powder, a $SrCO_3$ powder, a ZnO powder, a $Nb_2O_5$ powder, a $TiO_2$ powder and a $ZrO_2$ powder were prepared; and were weighed out to give the following composition. Then, these raw materials were wet mixed in a ball mill for 16 hours, and the mixture thus obtained was calcined in air at 700 to 900°C for 2 hours.
Main constituent:

$$(Pb_{0.995-0.03}Sr_{0.03})[(Zn_{1/3}Nb_{2/3})_{0.1}Ti_{0.43}Zr_{0.47}]O_3$$

The calcined mixture thus obtained was pulverized, and then wet milled in a ball mill for 16 hours. The milled mixture was dried, added with an acrylic resin as a binder, and then granulated. The granulated mixture was compacted into a disc of 17 mm in diameter and 1 mm in thickness with a uniaxial press molding machine under a pressure of approximately 445 MPa. After compacting, a Cu paste containing a Cu powder of 1.0 μm in particle size was printed on both sides of this disc. The pellet thus obtained was heat treated to evaporate the binder, and sintered at 950°C for 8 hours in a low-oxygen reductive atmosphere (oxygen partial pressure: $1.013 \times 10^{-5}$ to $1.013 \times 10^{-1}$ Pa ($1 \times 10^{-10}$ to $1 \times 10^{-6}$ atm)). The sintered body thus obtained was subjected to slicing machining and lapping machining into a 0.6 mm thick disc; then the printed Cu paste was removed and at the same time machined into a shape suitable for the property evaluation. A silver paste was printed on both sides of the obtained sample, and baked at 350°C. The sample was subjected to a polarization treatment in a silicone oil set at 120°C by applying an electric filed of 3 kV for 15 minutes.

A piezoelectric ceramic composition was prepared by following the above described method, and another piezoelectric ceramic composition for which no Cu paste printing was carried out was prepared. The two piezoelectric ceramic compositions thus prepared were subjected to a measurement of electric resistance (resistivity, hereinafter the same) IR and further a measurement of the electromechanical coupling coefficient kr (%). The measurement of the electromechanical coupling coefficient kr (%) was carried out by using an impedance analyzer (HP4194A, manufactured by Hewlett-Packard Co.). The results thus obtained are shown below. It may be noted that the electric resistance IR (relative value) means a value obtained by dividing the resistance value at 150°C of each of the piezoelectric ceramic compositions by the resistance value at 150°C for the case where no Cu paste coating was carried out.

    With Cu paste: Electric resistance IR (relative value) =
    124, kr (%) = 66.1%


    Without Cu paste: Electric resistance IR (relative value)
    = 1, kr (%) = 66.5%

As can be seen, in the piezoelectric ceramic composition printed with a Cu paste, the electric resistance at a high temperature has been drastically improved. However, the piezoelectric property (electromechanical coupling coefficient kr (%)) has been somewhat decreased.

The piezoelectric ceramic composition printed with a Cu paste was subjected to ICP (Inductively Coupled Plasma) analysis. A preparation method of a sample for ICP was as follows: first, 0.1 g of an analyte sample was added with 1 g of $Li_2B_2O_7$, and the mixture was melted at 1050°C for 15 minutes; the obtained molten was added with 0.2 g of $(COOH)_2$ and 10 ml of HCl, heated to be dissolved, and then the sample solution volume was adjusted so as to be 100 ml. The ICP measurement was carried out by using ICP-AES (trade name ICPS-8000, manufactured by Shimadzu Corp.). Consequently, it was found that Cu was contained in a content of approximately 0.1% by mass in terms of CuO. The Cu can be identified to have diffused from the Cu paste during the sintering process, because no Cu was contained in the raw materials of the piezoelectric ceramic composition.

Next, description will be made on the experiment for identifying the effect due to the addition of Cu as a component of the piezoelectric layers.

As the raw materials for the main constituent, a PbO powder, a $SrCO_3$ powder, a ZnO powder, a $Nb_2O_5$ powder, a $TiO_2$ powder and a $ZrO_2$ powder were prepared, and were weighed out to give the following composition. Then, these raw materials were wet mixed for 16 hours in a ball mill, and the mixture thus obtained was calcined in air at 700 to 900°C for 2 hours.
Main constituent:

$$(Pb_{0.995-0.03}Sr_{0.03})[(Zn_{1/3}Nb_{2/3})_{0.1}Ti_{0.43}Zr_{0.47}]O_3$$

The calcined mixture thus obtained was pulverized, added with CuO, and then wet milled for 16 hours in a ball mill. The milled mixture was dried, added with a vehicle, and then kneaded to prepare a piezoelectric layer paste. An internal electrode layer paste was also prepared by kneading a Cu powder as the conductive material with a vehicle. Then, by using the piezoelectric layer paste and the internal electrode layer paste, a green chip to be a precursor for a laminate was prepared by means of a printing method. The green chip was subject to a binder removal treatment, and then sintered under reductive sintering conditions to yield a laminate. The reductive sintering conditions were such that sintering was carried out in a reductive atmosphere (for example, under an oxygen partial pressure: $1.013 \times 10^{-5}$ to $1.013 \times 10^{-1}$ Pa ($1 \times 10^{-10}$ to $1 \times 10^{-6}$ atm)) at temperatures of 800 to 1200°C.

The obtained laminate was subjected to the electric resistance IR (relative value) measurement at a high temperature in the same manner as described above and a measurement of the dielectric constant ε. The results obtained are shown below.

Laminated body: Electric resistance IR (relative value) = 112, dielectric constant ε = 1646.

Bulk body: Electric resistance IR (relative value) = 124, dielectric constant ε = 1995.

The addition of Cu to the piezoelectric layers has drastically improved the electric resistance at a high temperature in the same manner as in the case where Cu was diffused from the internal electrode layers into the piezoelectric layers. And, the accompanying decrease of the dielectric constant $\varepsilon$ has been identified to be small.

Next, the piezoelectric layers 11 containing $CuO_\alpha$ ($\alpha \geq 0$) degrade the piezoelectric properties, and hence the present invention improves the piezoelectric strain constant by containing an oxide of a rare earth metal element in a content of 0.8% by mass or less (not inclusive of 0).

Preferred among the rare earth metal elements are Y and heavy rare earth metal elements; preferred among the heavy rare earth metal elements are Tb, Dy and Ho. Here, it is to be noted that the heavy rare earth metal elements mean the Gd and the elements listed thereafter in the above-listed rare earth metal elements.

The content of the oxide of a rare earth metal element to be contained in the piezoelectric layers 11 is 0.8% by mass or less (not inclusive of 0) in terms of the oxide concerned. This is because when the content of the oxide of a rare earth metal element exceeds 0.8% by mass, the piezoelectric properties are degraded as compared to the case where no oxide of a rare earth metal element is contained. The content of the oxide of a rare earth metal element is preferably 0.03 to 0.6% by mass, and more preferably 0.07 to 0.4% by mass.

The internal electrode layers 12 contain a conductive material. The present invention uses Cu as the conductive material. The use of Cu as the conductive material is useful for the low temperature sintering, for example, at 1050°C or lower.

The plurality of internal electrode layers 12 are alternately extended in opposite directions, and a pair of terminal electrodes 21 and 22 are disposed to be electrically connected to the alternate extension ends of the internal electrode layers 12, respectively. The terminal electrodes 21 and 22 are, for example, electrically connected to an external power supply not shown in the figure through the lead wires not shown in the figure.

The terminal electrodes 21 and 22 may be formed by sputtering with Cu, or alternatively, by baking a paste for the terminal electrodes. The thickness of each of the terminal electrodes 21 and 22 is appropriately determined depending on the intended purposes and other factors, and is usually 10 to 50 $\mu$m.

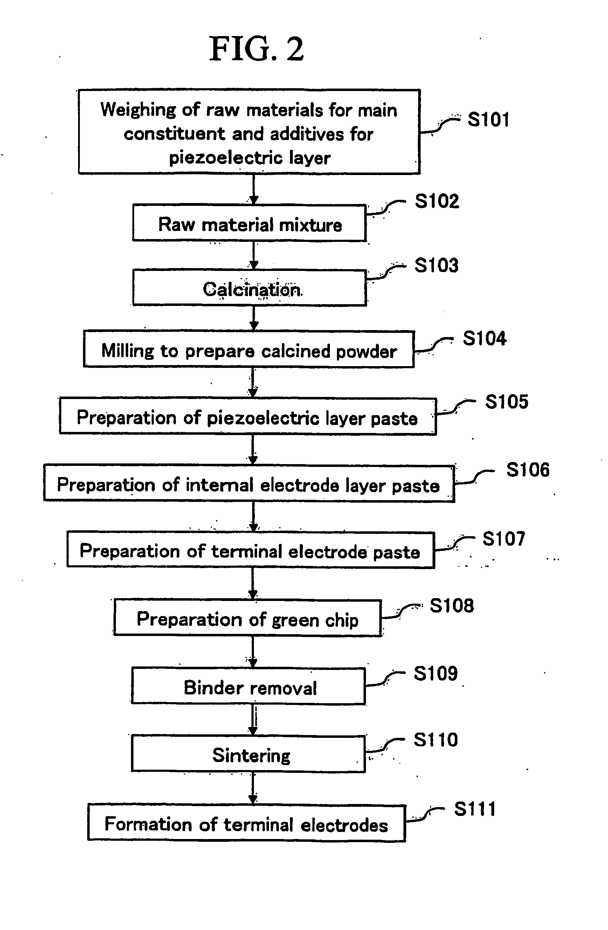

Next, description will be made on a preferable production method of the laminated piezoelectric element 1 with reference to FIG. 2. FIG. 2 is a flow chart showing a production process of the laminated piezoelectric element 1.

First, as the starting materials for the main constituent for the purpose of obtaining the piezoelectric layers 11, for example, the following are prepared and weighed out: the powders of PbO, $TiO_2$, $ZrO_2$, ZnO and $Nb_2O_5$, or the compounds that can be converted into these oxides by sintering; and the powder of at least one oxide selected from SrO, BaO and CaO or one selected from the compounds that can be converted into these oxides by sintering and the like (step S101). As the starting materials, instead of oxides, such materials as carbonates and oxalates that are converted into oxides by sintering may also be used. The raw material powders having an average particle size of 0.5 to 10 $\mu$m are usually used.

Each of the starting materials for the additives is prepared according to need and weighed out (step S101).

As the starting materials for the additives, instead of oxides, such materials as carbonates and oxalates that are converted into oxides by sintering may also be used as described above.

Subsequently, the starting materials for the main constituents and the additives are wet milled and mixed, for example, in a ball mill to yield the raw material mixture (step S102).

The starting materials for the additives may be added before the calcination (step S103) to be described below, or may be added after the calcination. It is to be noted that the addition before the calcination is preferable because the more homogeneous piezoelectric layers 11 can thereby be prepared; when added after calcination, oxides are preferably used for the starting materials for the additives.

Next, the raw material mixture is dried and calcined, for example, at temperatures of 750 to 950°C for 1 to 6 hours (step S103). This calcination may be carried out in air, in an atmosphere having an oxygen partial pressure higher than that in air, or in an atmosphere of pure oxygen. After calcination, the calcined mixture is wet milled and mixed, for example, in a ball mill to yield a calcined powder containing the main constituent and, if needed, additive(s) (step S104).

Next, the calcined powder is added with a binder to prepare a piezoelectric layer paste (step S105). Specifically, the involved procedures are as follows:

first, for example, in a ball mill, a slurry is prepared by wet milling; at this time, as the solvent for the slurry, water, alcohols such as ethanol, or a mixed solvent composed of water and ethanol can be used; and the wet milling is preferably carried out until the average particle size of the calcined powder becomes approximately 0.5 to 2.0 $\mu$m.

Next, the obtained slurry is dispersed in an organic vehicle. The organic vehicle means a mixture in which a binder is dissolved in an organic solvent. No particular constraint is imposed on the binders usable for the organic vehicle; such a binder may be appropriately selected from common various binders such as ethyl cellulose, polyvinyl butyral and acryls. Also, no particular constrain is imposed on the organic solvent concerned; such a solvent may be appropriately selected from organic solvents such as terpineol, butylcarbitol, acetone, toluene, and MEK (methyl ethyl ketone), according to the method to be applied such as printing and sheet forming.

When the piezoelectric layer paste is made to take a form of an aqueous coating composition, the calcined powder may be kneaded with an aqueous vehicle in which a water-soluble binder, a water-soluble dispersant or the like is dissolved in water. No particular constraint is imposed on the water-soluble binder to be used for the aqueous vehicle; for example, polyvinyl alcohol, cellulose, a water-soluble acrylic resin or the like may be used.

Additionally, the internal electrode layer paste is also prepared (step S106).

The internal electrode layer paste is prepared by kneading the above-mentioned various conductive materials or various oxides, organometallic compounds, resinates and the like to be converted after sintering into the above-mentioned conductive materials, with the above-mentioned organic vehicle.

In the sintering step to be described below, the Cu contained in the internal electrode layer paste diffuses into the piezoelectric layers 2 to be formed by sintering of the piezoelectric layer paste. In this diffusion, the particle size of the Cu contained in the internal electrode layer paste affects the diffusion quantity. When the particle size of the Cu contained in the internal electrode layer paste is large, the diffusion quantity is increased; when the particle size of the Cu is small, the diffusion quantity is decreased. For the purpose of preventing the decrease of the piezoelectric strain constant, the smaller diffusion quantity of the Cu is the more preferable. Accordingly, it is preferable that the particle size of Cu contained in the internal electrode layer paste is as small as possible.

A terminal electrode paste is also prepared in the same manner as the internal electrode layer paste (step S107).

In the above-mentioned case, the piezoelectric layer paste, the internal electrode layer paste and the terminal electrode paste are prepared sequentially in this order; however, needless to say, these pastes may be simultaneously prepared or in a reversed order.

No particular constraint is imposed on the content of the organic vehicle in each of the pastes; the typical content may be such that the content of the binder is approximately 5 to 10% by.mass and the content of the solvent is approximately 10 to 50% by mass. Additionally, each of the pastes may contain additives selected from various dispersants, plasticizers, dielectrics, insulators and the like.

Next, by using the above-mentioned pastes, a green chip (laminate) to be sintered is prepared (step S108).

When the green chip is prepared by means of a printing method, the piezoelectric layer paste is printed two or more times, in a predetermined thickness for each time, for example, on a substrate made of polyethylene terephthalate and the like, to form an outer piezoelectric layer 11a in a green state. Then, on the outer piezoelectric layer 11a in a green state, the internal electrode layer paste is printed in a predetermined pattern to form an internal electrode layer (an internal electrode layer precursor) 12a in a green state. Then, on the internal electrode layer 12a in a green state, the piezoelectric layer paste is printed two or more times, in a predetermined thickness for each time, in the same manner as described above, to form a piezoelectric layer (a piezoelectric layer precursor) 11b in a green state. Then, on the piezoelectric layer 11b in a green state, the internal electrode layer paste is printed in a predetermined pattern, to form an internal electrode layer 12b in a green state. The internal electrode layers 12a and 12b each in a green state are formed so as to be exposed respectively to the different end surfaces facing each other. The above-mentioned operations are repeated predetermined number of times, and finally, on the internal electrode layer 12 in a green state, the piezoelectric layer paste is printed, in the same manner as described above, predetermined numbers of times, in a predetermined thickness for each time, to form the outer piezoelectric layer 11c in a green state. Hereafter, the laminate thus obtained is pressurized and bonded while being heated, and then cut into a predetermined shape to form a green chip (laminate).

In the above case, description is made on the preparation of a green chip by means of a printing method; however, such a green chip can also be prepared by means of a sheet forming method.

Next, the green chip is subjected to a binder removal treatment (step S109).

In the binder removal treatment, the atmosphere of the binder removal is needed to be determined according to the conductive material in the internal electrode layer precursor. When a noble metal is used as the conductive material, the binder removal may be carried out in air, in an atmosphere having an oxygen partial pressure higher than that in air, or in an atmosphere of pure oxygen. When Cu is used as the conductive material, it is necessary to consider the oxidation, and a heating in a reductive atmosphere is to be adopted. On the other hand, in the binder removal treatment, it is necessary to consider the fact that the oxide contained in the piezoelectric layer precursor, for example, PbO is reduced. For example, when Cu is used as the conductive material, it is preferable to determine what reductive atmosphere is to be applied to the binder removal treatment on the basis of the equilibrium oxygen partial pressure of Cu and $Cu_2O$ (hereinafter, simply referred to as the equilibrium oxygen partial pressure of Cu) and the equilibrium oxygen partial pressure of Pb and PbO (hereinafter, simply referred to as the equilibrium oxygen partial pressure of Pb).

When the binder removal treatment temperature is lower than 300°C, the binder removal cannot be carried out smoothly. Also, when the binder removal treatment temperature exceeds 650°C, no binder removal effect commensurate with such a high temperature can be obtained to result in a waste of energy. The binder removal treatment time is needed to be determined according to the temperature and the atmosphere; the binder removal treatment time can be selected to fall within a range from 0.5 to 50 hours. Further, the binder removal treatment may be carried out separately and independently from the sintering, or may be carried out continuously with the sintering. When the binder removal treatment is' carried out continuously with the sintering, the binder removal treatment may be carried out in the course of the temperature elevation in sintering.

After the binder removal treatment, the sintering (step S110) is carried out.

The laminated piezoelectric element 1 is preferably sintered under reductive sintering conditions. In the preparation of the laminated piezoelectric element 1, sintering in an oxidative atmosphere necessitates, for example, the use of a noble metal as the electrode material for the internal electrode layers 12. On the contrary, the laminated piezoelectric element 1 is a product obtained by sintering in the reductive sintering conditions, and hence low price Cu can be used for the internal electrode layers 12 in the present invention. The reductive sintering conditions are, for example, such that the sintering temperature is 800°C to 1200°C and the oxygen partial pressure is $1.013 \times 10^{-5}$ to $1.013 \times 10^{-1}$ Pa ($1 \times 10^{-10}$ to $1 \times 10^{-6}$ atm).

When the sintering temperature is lower than 800°C, the sintering does not proceed to a sufficient extent. When the sintering temperature exceeds 1200°C, the melting of Cu is feared. The sintering temperature is preferably 850 to 1100°C and more preferably 900 to 1050°C.

When the oxygen partial pressure is less than $1 \times 10^{-10}$ atm, there is a fear that the oxide contained in the piezoelectric layer precursor, for example, PbO is reduced, metallic Pb is thereby deposited, and the piezoelectric properties of the finally obtained sintered body are degraded. When the oxygen partial pressure exceeds $1.013 \times 10^{-1}$ Pa ($1 \times 10^{-6}$ atm), the oxidation of Cu as the electrode material is feared. The oxygen partial pressure is preferably $1.023 \times 10^{-4}$ to $1.013 \times 10^{-2}$ Pa ($1 \times 10^{-9}$ to $1 \times 10^{-7}$ atm) and more preferably $1.013 \times 10^{-3}$ to $1.013 \times 10^{-2}$ Pa ($1 \times 10^{-8}$ to $1 \times 10^{-7}$ atm).

When the sintering is carried out under the above described reductive sintering conditions, the degradation of the electric resistance at high temperatures becomes an issue; however, in the case of the laminated piezoelectric element of the present invention, this issue can be avoided by containing $CuO_\alpha$ ($\alpha \geq 0$) in the piezoelectric layers 11 as described above. In other words, the laminated piezoelectric element 1 of the present invention is a product obtained by sintering under the reductive sintering conditions, and hence Cu can be used for the internal electrode layers 12. In addition to this, the degradation of the high temperature load life accompanying the degradation of the electric resistance can be eliminated. Additionally, the degradation of the piezoelectric properties caused by containing $CuO_\alpha$ ($\alpha \geq 0$) in the piezoelectric layers 11 can be avoided by containing a predetermined content of a rare earth metal element.

The laminate 10 prepared by carrying out the above-mentioned steps is subjected to end face polishing by means of, for example, barrel polishing or sandblast, and then the terminal electrodes 21 and 22 are formed by printing or baking the above-mentioned terminal electrode paste (step S111). The terminal electrodes 21 and 22 can also be formed by sputtering instead of printing or baking.

In the above described manner, the laminated piezoelectric element 1 shown in FIG. 1 can be obtained.

[Examples]

Hereinafter, the present invention will be described on the basis of specific Examples.

<Example 1>

Examples 1 to 8 describe examples of the improvement of the high temperature electric resistance due to the presence of the $CuO_\alpha$ and examples of the improvement of the piezoelectric property due to the addition of the second additive.

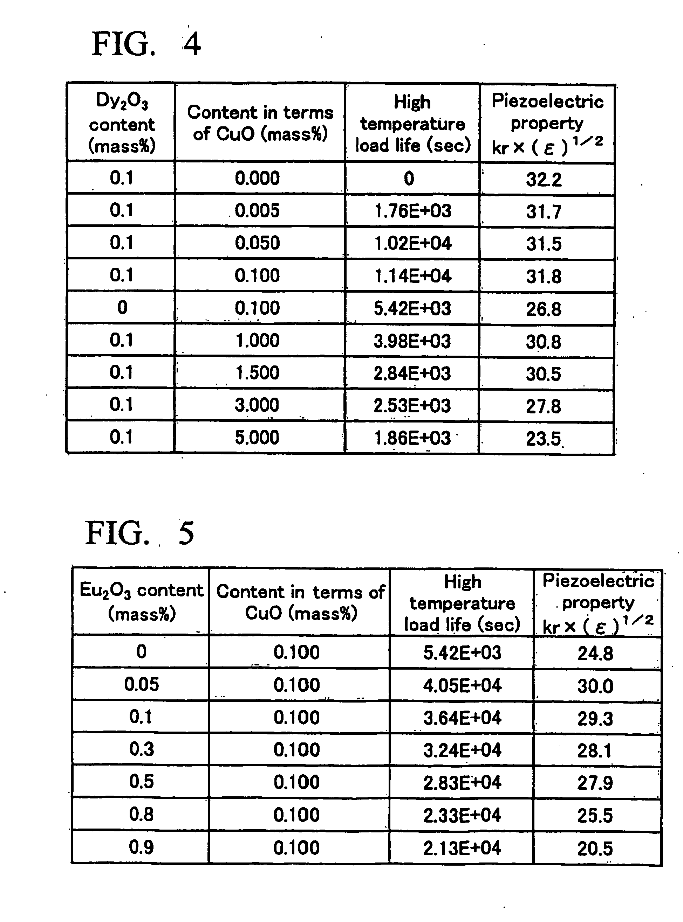

In Example 1, there were prepared piezoelectric ceramic compositions in each of which $Dy_2O_3$ was added as the oxide of a rare earth metal element in the content shown in FIG. 4 and CuO as $CuO_\alpha$ ($\alpha \geq 0$) was added in the content shown in FIG. 4, in relation to the main constituent shown below. The effects of $CuO_\alpha$ ($\alpha \geq 0$) and $Dy_2O_3$ were examined.
Main constituent:

$$(Pb_{0.995-0.03}Sr_{0.03}) [(Zn_{1/3}Nb_{2/3})_{0.1}Ti_{0.43}Zr_{0.47}]O_3$$

Each of the piezoelectric ceramic compositions shown in FIG. 4 was prepared as follows. First, as the raw materials for the main constituent, a PbO powder, a $SrCO_3$ powder, a ZnO powder, a $Nb_2O_5$ powder, a $TiO_2$ powder, a $ZrO_2$ powder and a rare earth oxide powder were prepared, and were weighed out to give the above-mentioned composition of the main constituent. Then, these raw materials were wet mixed with a ball mill for 16 hours, and calcined in air at 700 to 900°C for 2 hours.

The calcined mixture thus obtained was pulverized and combined with a raw material for $CuO_\alpha$ ($\alpha \geq 0$) (added species: CuO), and then wet milled with a ball mill for 16 hours. The milled mixture was dried, combined with an acrylic resin as a binder, and then granulated. The granulated mixture was compacted into a disc of 17 mm in diameter and 1 mm in thickness with a uniaxial press molding machine under a pressure of approximately 445 MPa. After compacting, the disc.was heat treated to evaporate the binder, and then sintered at 950°C for 2 to 8 hours in a low-oxygen reductive atmosphere (oxygen partial pressure: $1.013 \times 10^{-5}$ to $1.013 \times 10^{-1}$ Pa ($1 \times 10^{-10}$ to $1 \times 10^{-6}$ atm)). The sintered body thus obtained was lapped into a 0.6 mm thick disc; then silver electrodes were formed on both sides of the disc by an evaporation method, and the disc was subjected to a polarization treatment in a silicone oil set at 120°C by applying an electric field of 3 kV for 15 minutes.

The piezoelectric ceramic composition thus prepared was subjected to a high temperature load life test, and further to piezoelectric property evaluation.

The high temperature load life test is a test in which five specimens were used; a voltage of 3.2 kV was applied to each of the specimens at 250°C so as for the electric field strength to be 8 kV/mm, and the time variation of the electric resistance of the specimen was measured; the life time of each of the specimens was defined as the time required for the electric resistance of the specimen to decrease by at least 0.5 orders of magnitude with respect to the electric resistance at the start of the test; the high temperature load life was the average of the five values thus measured.

The piezoelectric property was evaluated as the product between the electromechanical coupling coefficient kr (%) and the square root of the dielectric constant ($\varepsilon^{1/2}$). The electromechanical coupling coefficient kr (%) measurement was carried out by using an impedance analyzer (HP4194A, manufactured by Hewlett-Packard Co.). The results thus obtained are shown in FIG. 4. It is to be noted that "E+On" in the column under the heading of the "high temperature load life" in FIG. 4 means "$\times 10^n$." Accordingly, for example, "1.76E+03" in FIG. 4 means "$1.76 \times 10^3$" and, for example, "1.14E+04" means "$1.14 \times 10^4$." Hereinafter, the representation "E+On" has the same meaning.

As can be seen from FIG. 4, the addition of CuO improves the high temperature load life. As can also be seen, although the addition of CuO leads to a tendency to degrade the piezoelectric property, the addition of $Dy_2O_3$ as the oxide of a rare earth metal element can prevent the degradation of the piezoelectric property. CuO is effective in an addition of 5.0% by mass for the high temperature load life, but degrades the piezoelectric property in addition exceeding 3.0% by mass. Accordingly, in the present invention, the content of $CuO_\alpha$ is set at 3.0% by mass or less in terms of CuO.

<Example 2>

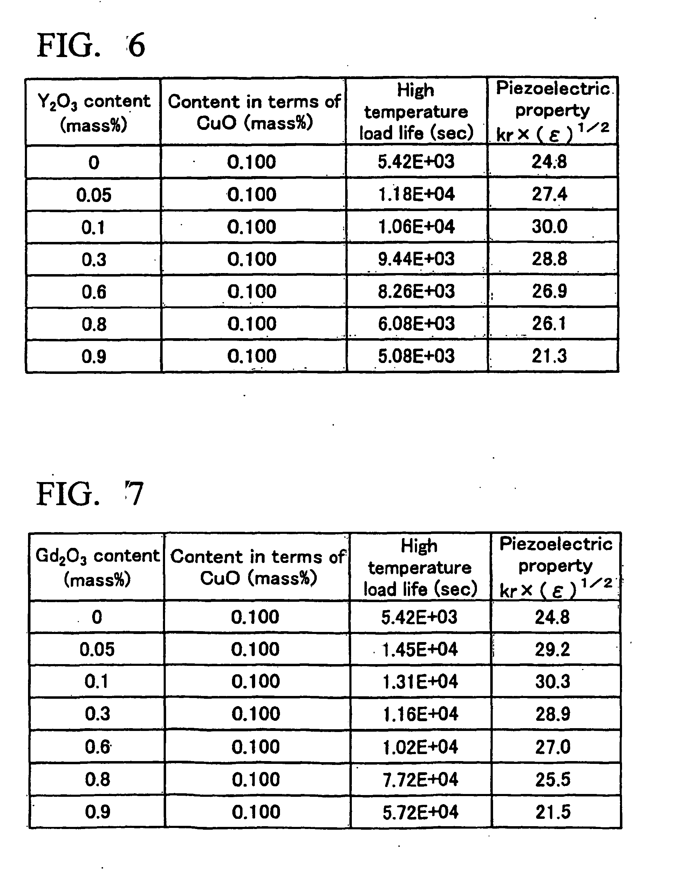

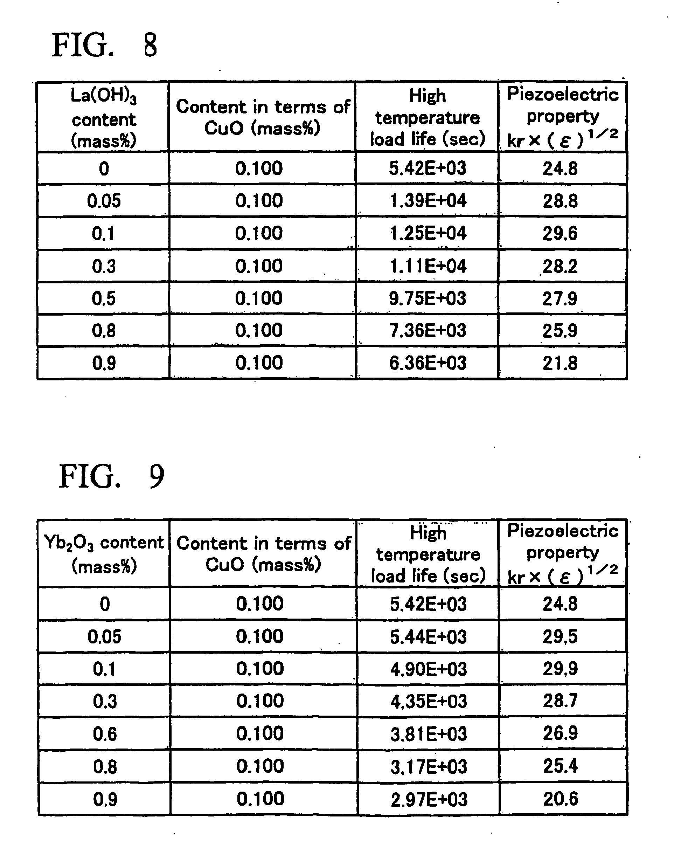

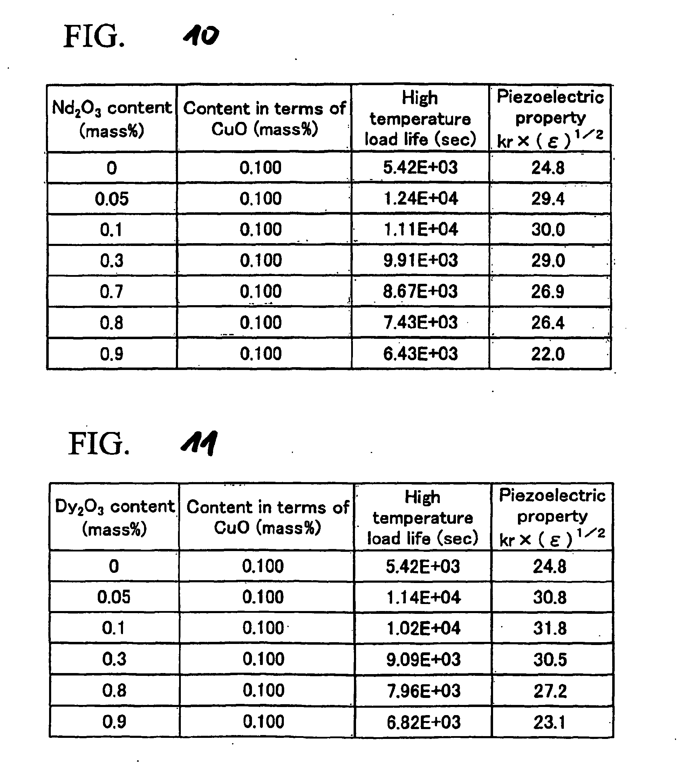

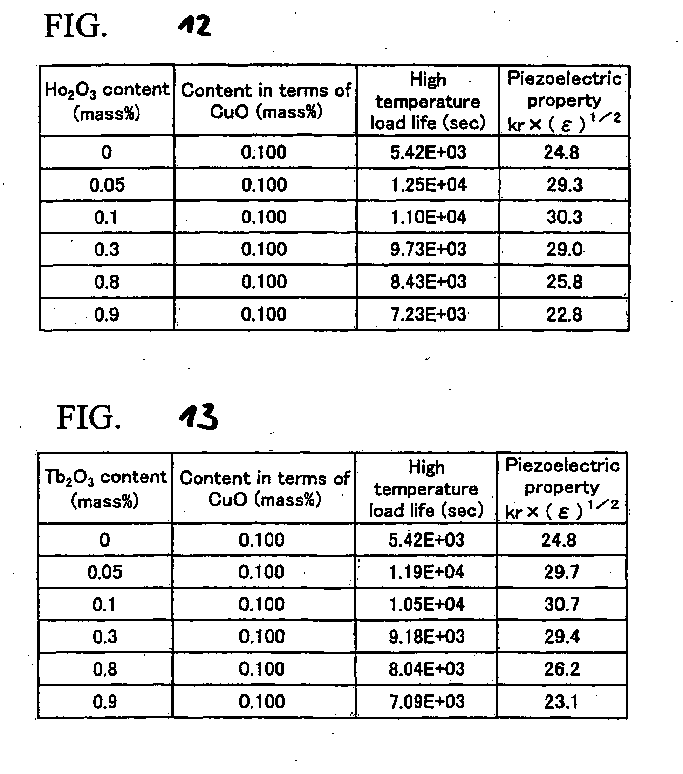

Example 2 presents the results of the experiments to verify the effects of the oxides of various rare earth metal elements by varying the contents of the oxides as shown in FIGS. 5 to 14. The piezoelectric ceramic compositions were prepared in the same manner as in Example 1 (after pulverization of the calcined mixtures, the raw material of $CuO_\alpha$ ($\alpha \geq 0$) (added species: CuO) was added in a content of 0.100% by mass), and the high temperature load life and the piezoelectric property were evaluated in the same manner as in Example 1. The results thus obtained are shown in FIGS. 5 to 14.

As can be seen from FIGS. 5 to 14, the addition of the various rare earth metal elements to the piezoelectric ceramic compositions can improve the piezoelectric property. Gd, Dy, Ho and Tb are high in the improvement effect on the piezoelectric property, and in particular, Dy is excellent because Dy can attain excellent piezoelectric properties over a wide addition range thereof.

<Example 3>

Example 3 presents the results of the experiments in which examination was carried out on the composition "a" of the A-site element of the main constituent.

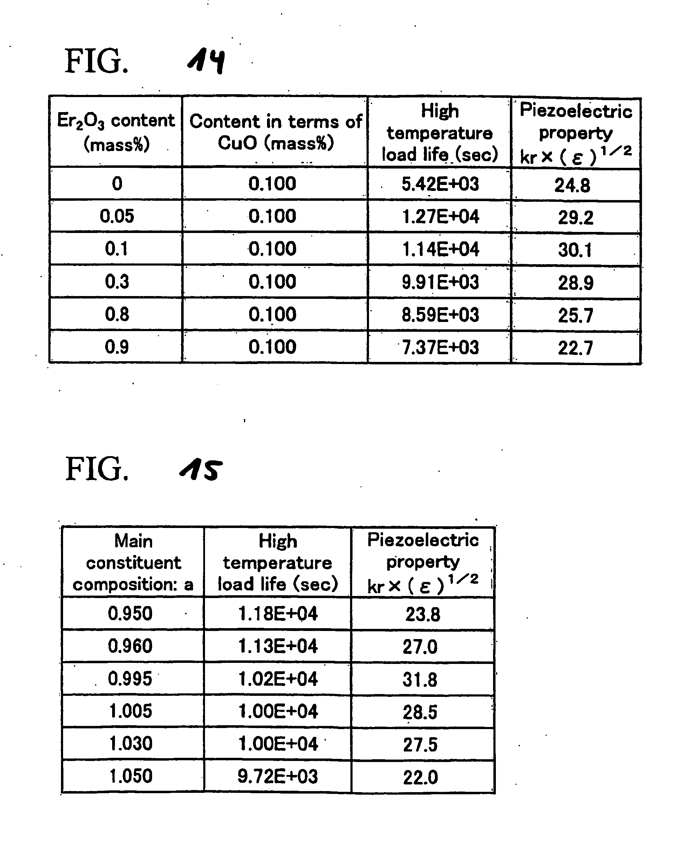

Piezoelectric ceramic composition were prepared by setting the composition of the main constituent as shown' below, and by varying the composition a in the composition of the main constituent. The preparation method of each of the piezoelectric ceramic compositions was the same as that in Example 1; a calcined mixture prepared by adding $Dy_2O_3$ in a content of 0.1% by mass was pulverized, and then the pulverized mixture was combined with the raw material for $CuO_\alpha$ ($\alpha \geq 0$) (added species: CuO) in a content of 0.1% by mass. Each of the thus obtained piezoelectric ceramic compositions was subjected to the evaluation of the high temperature load life and the piezoelectric property in the same manner as in Example 1. The results thus obtained are shown in FIG. 15; it has been verified that when the composition "a" falls within a range from 0.96 to 1.03, piezoelectric ceramic compositions excellent in high temperature load life and piezoelectric property can be obtained.

Main constituent:

$$(Pb_{a-0.03}Sr_{0.03})[(Zn_{1/3}Nb_{2/3})_{0.1}Ti_{0.43}Zr_{0.47}]O_3$$

<Example 4>

Example 4 presents the results of the experiments in which examination was carried out on the composition b of the A-site element of the main constituent.

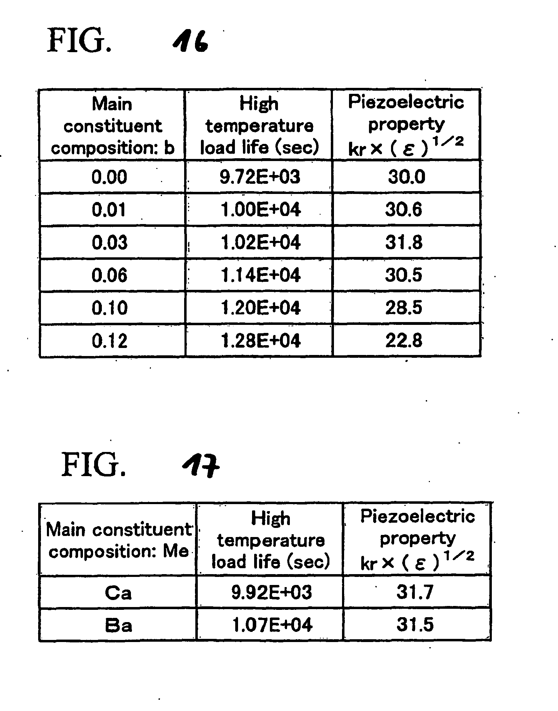

Piezoelectric ceramic compositions were prepared by setting the composition of the main constituent as shown below, and by varying the composition b in the composition of the main constituent. The preparation method of each of the piezoelectric ceramic compositions was the same as that in Example 1; a calcined mixture prepared by adding $Dy_2O_3$ in a content of 0.1% by mass was pulverized, and then the pulverized mixture was combined with the raw material for $CuO_\alpha$ ($\alpha \geq 0$) (added species: CuO) in a content of 0.1% by mass. Each of the thus obtained piezoelectric ceramic compositions was subjected to the evaluation of the high temperature load life and the piezoelectric property in the same manner as in Example 1. The results thus obtained are shown in FIG. 16; it has been verified that when the composition b falls within a range of $0 \leq b \leq 0.1$, piezoelectric ceramic compositions excellent in high temperature load life and piezoelectric property can be obtained.
Main constituent:

$$(Pb_{0.995-b}Sr_b)[(Zn_{1/3}Nb_{2/3})_{0.1}Ti_{0.43}Zr_{0.47}]\,O_3$$

<Example 5>

Example 5 presents the results of the experiments which were carried out by using Ca or Ba instead as the A-site substitutional element Me in the main constituent.

Piezoelectric ceramic compositions were prepared by setting the composition of the main constituent as shown below, and otherwise in the same manner as in Example 1. Specifically, for each of the piezoelectric ceramic compositions, a calcined mixture prepared by adding $Dy_2O_3$ in a content of 0.1% by mass was pulverized, and then the pulverized mixture was combined with the raw material for $CuO_\alpha$ ($\alpha \geq 0$) (added species: CuO) in a content of 0.1% by mass. Each of the thus obtained piezoelectric ceramic compositions was subjected to the evaluation of the high temperature load life and the piezoelectric property in the same manner as in Example 1. The results thus obtained are shown in FIG. 17; it has been verified that when the substitutional element Me in the main constituent is changed from Sr to Ca or Ba, piezoelectric ceramic compositions excellent in high temperature load life and piezoelectric property can also be obtained.
Main constituent:

$$(Pb_{0.995-0.03}Me_{0.03})[(Zn_{1/3}Nb_{2/3})_{0.1}Ti_{0.43}Zr_{0.47}]O_3$$

<Example 6>

Example 6 presents the results of the experiments in which examination was carried on x, y and z of the B-site elements of the main constituent.

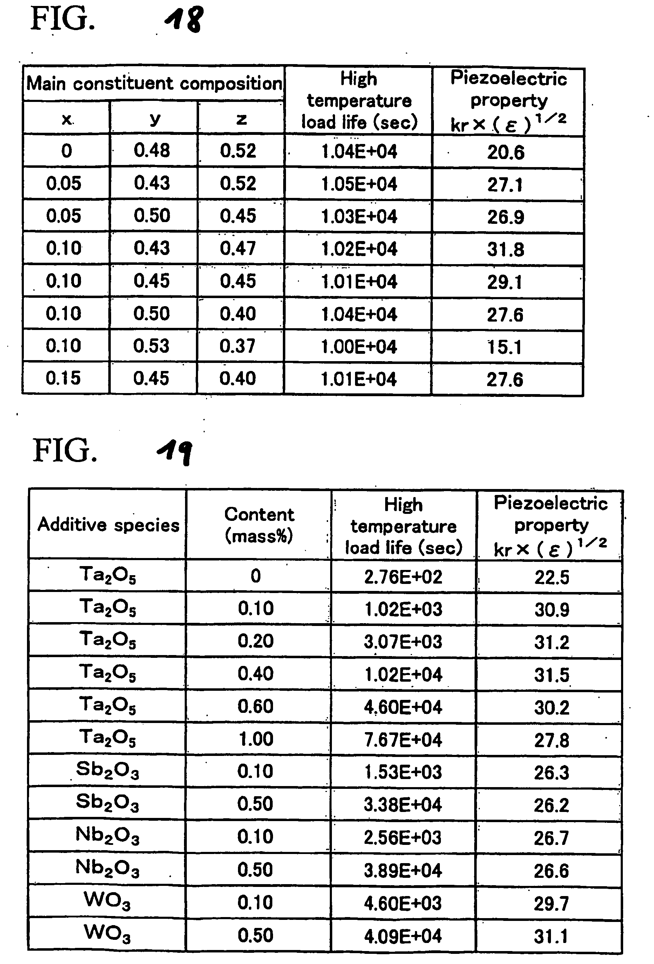

Piezoelectric ceramic compositions were prepared by setting the composition of the main constituent as shown below, and by varying x, y and z of the B-site elements of the composition in the main constituent. The preparation method of each of the piezoelectric ceramic compositions was the same as that in Example 1; a calcined mixture prepared by adding $Dy_2O_3$ in a content of 0.1% by mass was pulverized, and then the pulverized mixture was combined with the raw material for $CuO_\alpha$ ($\alpha \geq 0$) (added species: CuO) in a content of 0.1% by mass. Each of the thus obtained piezoelectric ceramic compositions was subjected to the evaluation of the high temperature load life and the piezoelectric property in the same manner as in Example 1. The results thus obtained are shown in FIG. 18. As shown in FIG. 18, it has been verified that even when x, y and z of the B-site elements are varied within the ranges of the present invention, piezoelectric ceramic compositions excellent in high temperature load life and piezoelectric property can be obtained.
Main constituent:

$$(Pb_{0.995-0.03}Sr_{0.03})[(Zn_{1/3}Nb_{2/3})_x Ti_y Zr_z]O_3$$

<Example 7>

Example 7 presents the results of the experiments which were carried out by adding each of the substances shown in FIG. 19 as the fourth additive in relation to the main constituent.

Piezoelectric ceramic compositions were prepared in the same manner as in Example 1 except that the composition of the main constituent was set as shown below, and the substances shown in FIG. 19 were added. In other words, a calcined mixture prepared by adding $Dy_2O_3$ in a content of 0.1% by mass was pulverized, and then the pulverized mixture was combined with the raw material for $CuO_\alpha$ ($\alpha \geq 0$) (added species: CuO) in a content of 0.1% by mass. Each of the thus obtained piezoelectric ceramic compositions was subjected to the evaluation of the high temperature load life and the piezoelectric property in the same manner as in Example 33. The results thus obtained are shown in FIG. 19. As shown in FIG. 19, it has been verified that any additives and any additive amounts attain advantageous effects, and piezoelectric ceramic compositions excellent in high temperature load life and piezoelectric property can be obtained. Main constituent:

$$(Pb_{0.995-0.03}Sr_{0.03})[(Zn_{1/3}Nb_{2/3})_{0.1}Ti_{0.43}Zr_{0.47}]O_3$$

<Example 8>

Example 8 presents an example of the preparation of a laminated piezoelectric element.

In the preparation of the laminated piezoelectric element, first a vehicle was added to a piezoelectric ceramic composition powder obtained by pulverizing the calcined mixture ($Dy_2O_3$ was added in a content of 0.1% by mass) obtained in Example 1. The mixture thus obtained was kneaded to prepare a piezoelectric layer paste. A Cu powder as a conductive material was kneaded with a vehicle to prepare an internal electrode layer paste. Then, by using the piezoelectric layer paste and the internal electrode layer paste, a green chip as a precursor for a laminate was prepared by means of a printing method. The green chip was subject to a binder removal treatment, and then sintered under reductive sintering conditions to yield a laminate. The reductive sintering conditions were such that sintering was carried out in a reductive atmosphere (for example, under an oxygen partial pressure: $1.013 \times 10^{-5}$ to $1.013 \times 10^{-1}$ Pa ($1 \times 10^{-10}$ to $1 \times 10^{-6}$ atm)), at sintering temperatures of 800 to 1200°C.

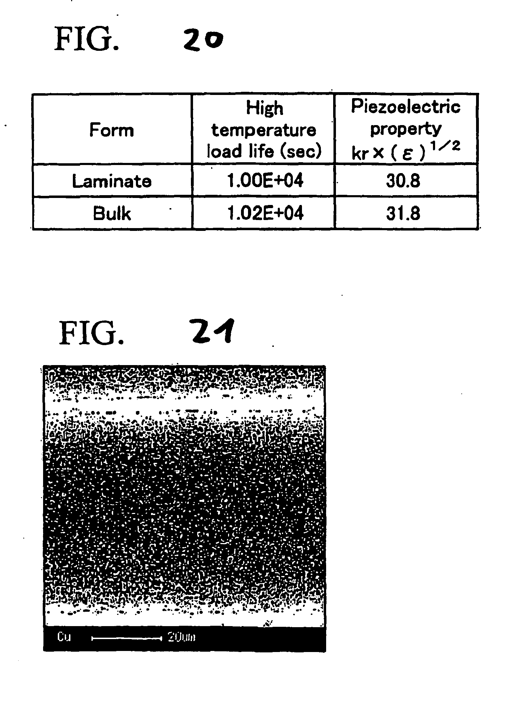

The laminate thus obtained was subjected to a laminate section measurement by using an EPMA (EPMA-1600). The obtained laminate was also subjected to the measurements of the high temperature load life and the piezoelectric property in the same manner as in Example 1. The results thus obtained are shown in FIG. 20.

The piezoelectric layers forming the laminate were sintered as a laminate, and consequently, the Cu of the electrodes diffused into the piezoelectric layers, and the high temperature electric resistance was markedly improved. The state of the presence of the Cu in the piezoelectric layers was examined by means of an EPMA; as shown in FIG. 21, the Cu did not show any segregation but was present uniformly.

**Claims**

1. A piezoelectric ceramic composition comprising:

   (i) as a main constituent thereof a composite oxide represented by the formula

   $$(Pb_{a-b}Me_b)[(Zn_{1/3}Nb_{2/3})_xTi_yZr_z]O_3.$$

   wherein
   $0.96 \leq a \leq 1.03$,
   $0.005 \leq b \leq 0.08$,
   $0.05 \leq x \leq 0.15$,
   $0.25 \leq y \leq 0.5$,
   $0.35 \leq z \leq 0.6$,
   $x + y + z = 1$, and
   Me is at least one of Sr, Ca and Ba;
   (ii) more than 0 to 0.8 wt.-%, in terms of oxide and in relation to the composite oxide (i), of a rare earth metal element as a first additive; and
   (iii) more than 0 to 3.0 wt.-%, in terms of CuO and in relation to the composite oxide (i), of $CuO_\alpha$ ($\alpha \geq 0$) as a second additive.

2. The piezoelectric ceramic composition of claim 1, comprising more than 0 to 1.0 wt.-%, in terms of oxide, of at least one of Ta, Sb, Nb and W as a third additive.

3. A method of producing a laminated piezoelectric element, comprising the steps of laminating with each other

(a) piezoelectric layer precursors comprising a piezoelectric ceramic composition comprising:

(i) as a main constituent thereof a composite oxide represented by the formula

$$(Pb_{a-b}Me_b)[(Zn_{1/}Nb_{2/3})_xTi_yZr_z]O_3$$

wherein
$0.96 \leq a \leq 1.03$,
$0.005 \leq b \leq 0.08$,
$0.05 \leq x \leq 0.15$,
$0.25 \leq y \leq 0.5$,
$0.35 \leq z \leq 0.6$,
$x + y + z = 1$, and
Me is at least one of Sr, Ca and Ba;
(ii) more than 0 to 0.8 wt.-%, in terms of oxide and in relation to the composite oxide (i), of a rare earth metal element as a first additive; and
(iii) optionally $CuO_\alpha$ ($\alpha \geq 0$) as a second additive, and

(b) internal electrode precursors comprising Cu;
and sintering in a reductive atmosphere to diffuse the Cu contained in the internal electrode precursors into the piezoelectric layers to obtain a laminate, wherein the composition of the piezoelectric layers comprises the composite oxide (i) and the rare earth metal element (ii) as defined above, and
(iii) more than 0 to 3.0 wt.-%, in terms of CuO and in relation to the composite oxide (i), of $CuO_\alpha$ ($\alpha \geq 0$) as a second additive.

4. The method of claim 3, wherein the piezoelectric ceramic composition further comprises 0 to 1.0 wt.-%, in terms of oxide, of at least one of Ta, Sb, Nb and W as a third additive.

5. The method of claim 3 or 4, wherein the sintering step is conducted at a sintering temperature of 800-1,200°C under an oxygen partial pressure of $1.013 \times 10^{-5}$ to $1.013 \times 10^{-1}$ Pa ($10^{-10}$ to $10^{-6}$ atm.).

6. A laminated piezoelectric element comprising:

(a) a plurality of piezoelectric layers comprising the piezoelectric ceramic composition of claim 1 or 2; and
(b) a plurality of internal electrode layers formed between said piezoelectric layers and comprising Cu as a conductive material.

**Patentansprüche**

1. Piezoelektrische Keramikzusammensetzung, umfassend:

(i) als Hauptbestandteil davon ein Verbundoxid, dargestellt durch die Formel

$$(Pb_{a-b}Me_b)[(Zn_{1/3}NB_{2/3})_xTi_yZr_z]O_3$$

worin
$0{,}96 \leq a \leq 1{,}03$,
$0{,}005 \leq b \leq 0{,}08$,
$0{,}05 \leq x \leq 0{,}15$,
$0{,}25 \leq y \leq 0{,}5$,
$0{,}35 \leq z \leq 0{,}6$,
$x + y + z = 1$ und
Me zumindest eines von Sr, Ca und Ba ist;
(ii) mehr als 0 bis 0,8 Gew.%, ausgedrückt als Oxid und in Beziehung zum Verbundoxid (i), von einem Seltenerdmetallelement als erstes Additiv; und
(iii) mehr als 0 bis 3,0 Gew.%, ausgedrückt als CuO und in Beziehung zum Verbundoxid (i), von $CuO_\alpha$ ($\alpha \geq 0$) als zweites Additiv.

**2.** Piezoelektrische Keramikzusammensetzung nach Anspruch 1, umfassend mehr als 0 bis 1,0 Gew.%, ausgedrückt als Oxid, von mindestens einem von Ta, Sb, Nb und W als drittes Additiv.

**3.** Verfahren zur Erzeugung eines laminierten piezoelektrischen Elementes, umfassend die Schritte des miteinander Laminierens:

(a) piezoelektrische Schichtvorläufer, umfassend eine piezoelektrische Keramikzusammensetzung, umfassend:

(i) als Hauptbestandteil davon ein Verbundoxid, dargestellt durch die Formel

$$(Pb_{a-b}Me_b)[(Zn_{1/3}NB_{2/3})_xTiyZr_z]O_3$$

worin
$0,96 \leq a \leq 1,03$,
$0,005 \leq b \leq 0,08$,
$0,05 \leq x \leq 0, 15$,
$0,25 \leq y \leq 0,5$,
$0,35 \leq z \leq 0, 6$,
$x + y + z = 1$ und
Me zumindest eines von Sr, Ca und Ba ist;
(ii) mehr als 0 bis 0,8 Gew.%, ausgedrückt als Oxid und in Beziehung zum Verbundoxid (i), von einem Seltenerdmetallelement als erstes Additiv; und
(iii) wahlweise $CuO_\alpha$ ($\alpha \geq 0$) als zweites Additiv; und

(b) interne Elektrodenvorläufer, umfassend Cu; und Sintern in einer reduktiven Atmosphäre, zum Diffundieren des Cu, das in den internen Elektrodenvorläufern enthalten ist, in die piezoelektrischen Schichten, unter Erhalt eines Laminates, worin die Zusammensetzung der piezoelektrischen Schichten das Verbundoxid (i) und das Seltenerdmetallelement (ii) wie oben definiert umfasst; und
(iii) mehr als 0 bis 3,0 Gew.%, ausgedrückt als CuO und in Bezug auf das Verbundoxid (i), $CuO_\alpha$ ($\alpha \geq 0$) als zweites Additiv.

**4.** Verfahren nach Anspruch 3, worin die piezoelektrische Keramikzusammensetzung weiterhin 0 bis 1,0 Gew.%, als Oxid, von zumindest einem von Ta, Sb, Nb und W als drittes Additiv umfasst.

**5.** Verfahren nach Anspruch 3 oder 4, worin der Sinterschritt bei einer Sintertemperatur von 800 bis 1200°C unter einem Sauerstoffpartialdruck von $1,013 \times 10^{-5}$ bis $1,013 \times 10^{-1}$ Pa ($10^{-10}$ bis $10^{-6}$ atm) durchgeführt wird.

**6.** Laminiertes piezoelektrisches Element, umfassend:

(a) eine Vielzahl von piezoelektrischen Schichten, umfassend die piezoelektrische Keramikzusammensetzung nach Anspruch 1 oder 2; und
(b) eine Vielzahl von internen Elektrodenschichten, die zwischen den piezoelektrischen Schichten gebildet sind und Cu als leitendes Material umfassen.

**Revendications**

**1.** Composition de céramique piézoélectrique comprenant :

(i) en tant que constituant principal de celle-ci un oxyde composite représenté par la formule

$$(Pb_{a-b}Me_b) [(Zn_{1/3}Nb_{2/3})xTi_yZr_z]O_3$$

dans laquelle
$0,96 \leq a \leq 1,03$,
$0,005 \leq b \leq 0,08$,
$0,05 \leq x \leq 0,15$,

$0{,}25 \leq y \leq 0{,}5,$

$0{,}35 \leq z \leq 0{,}6,$

$x + y + z = 1$ , et

Me est au moins l'un parmi Sr, Ca et Ba ;

(ii) plus de 0 à 0,8 % en poids, en termes d'oxyde et par rapport à l'oxyde composite (i), d'un élément métallique des terres rares en tant que premier additif ; et

(iii) plus de 0 à 3,0 % en poids, en termes de CuO et par rapport à l'oxyde composite (i), de $CuO_{\alpha}$ ($\alpha \geq 0$) en tant que deuxième additif.

2. Composition de céramique piézoélectrique selon la revendication 1, comprenant plus de 0 à 1,0 % en poids, en termes d'oxyde, d'au moins l'un parmi Ta, Sb, Nb et W en tant que troisième additif.

3. Procédé de production d'un élément piézoélectrique multicouche, comprenant les étapes de disposition en couches les uns par rapport aux autres

(a) de précurseurs de couches piézoélectriques comprenant une composition de céramique piézoélectrique comprenant :

(i) en tant que constituant principal de celle-ci un oxyde composite représenté par la formule

$$(Pb_{a-b}Me_b) \ [(Zn_{1/3}Nb_{2/3})_x Ti_y Zr_z]O_3$$

dans laquelle

$0{,}96 \leq a \leq 1{,}03,$

$0{,}005 \leq b \leq 0{,}08,$

$0{,}05 \leq x \leq 0{,}15,$

$0{,}25 \leq y \leq 0{,}5,$

$0{,}35 \leq z \leq 0{,}6,$

$x + y + z = 1$, et

Me est au moins l'un parmi Sr, Ca et Ba ;

(ii) plus de 0 à 0,8 % en poids, en termes d'oxyde et par rapport à l'oxyde composite (i), d'un élément métallique des terres rares en tant que premier additif ; et

(iii) optionnellement $CuO_{\alpha}$ ($\alpha \geq 0$) en tant que deuxième additif, et

(b) de précurseurs d'électrodes internes comprenant du Cu ;

et de frittage dans une atmosphère réductrice pour diffuser le Cu contenu dans les précurseurs d'électrodes internes dans les couches piézoélectriques afin d'obtenir une structure multicouche dans lequel la composition des couches piézoélectriques comprend l'oxyde composite (i) et l'élément métallique des terres rares (ii) tels que définis ci-dessus, et

(iii) plus de 0 à 3,0 % en poids, en termes de CuO et par rapport à l'oxyde composite (i), de $CuO_{\alpha}$ ($\alpha \geq 0$) en tant que deuxième additif.

4. Procédé selon la revendication 3, dans lequel la composition de céramique piézoélectrique comprend en outre 0 à 1,0 % en poids, en termes d'oxyde, d'au moins l'un parmi Ta, Sb, Nb et W en tant que troisième additif.

5. Procédé selon la revendication 3 ou 4, dans lequel l'étape de frittage est effectuée à une température de frittage de 800 - 1 200 °C sous une pression partielle d'oxygène de $1{,}013 \times 10^{-5}$ à $1{,}013 \times 10^{-1}$ Pa ($10^{-10}$ à $10^{-6}$ atm.).

6. Élément piézoélectrique multicouche comprenant :

(a) une pluralité de couches piézoélectriques comprenant la composition de céramique piézoélectrique selon la revendication 1 ou 2 ; et

(b) une pluralité de couches d'électrodes internes formées entre lesdites couches piézoélectriques et comprenant du Cu en tant que matériau conducteur.

FIG. 1

# FIG. 2

Weighing of raw materials for main
constituent and additives for
piezoelectric layer ⟶ S101

Raw material mixture ⟶ S102

Calcination. ⟶ S103

Milling to prepare calcined powder ⟶ S104

Preparation of piezoelectric layer paste ⟶ S105

Preparation of internal electrode layer paste ⟶ S106

Preparation of terminal electrode paste ⟶ S107

Preparation of green chip ⟶ S108

Binder removal ⟶ S109

Sintering ⟶ S110

Formation of terminal electrodes ⟶ S111

FIG. 3

## FIG. 4

| Dy$_2$O$_3$ content (mass%) | Content in terms of CuO (mass%) | High temperature load life (sec) | Piezoelectric property $kr \times (\varepsilon)^{1/2}$ |
|---|---|---|---|
| 0.1 | 0.000 | 0 | 32.2 |
| 0.1 | 0.005 | 1.76E+03 | 31.7 |
| 0.1 | 0.050 | 1.02E+04 | 31.5 |
| 0.1 | 0.100 | 1.14E+04 | 31.8 |
| 0 | 0.100 | 5.42E+03 | 26.8 |
| 0.1 | 1.000 | 3.98E+03 | 30.8 |
| 0.1 | 1.500 | 2.84E+03 | 30.5 |
| 0.1 | 3.000 | 2.53E+03 | 27.8 |
| 0.1 | 5.000 | 1.86E+03 | 23.5 |

## FIG. 5

| Eu$_2$O$_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 4.05E+04 | 30.0 |
| 0.1 | 0.100 | 3.64E+04 | 29.3 |
| 0.3 | 0.100 | 3.24E+04 | 28.1 |
| 0.5 | 0.100 | 2.83E+04 | 27.9 |
| 0.8 | 0.100 | 2.33E+04 | 25.5 |
| 0.9 | 0.100 | 2.13E+04 | 20.5 |

# FIG. 6

| $Y_2O_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.18E+04 | 27.4 |
| 0.1 | 0.100 | 1.06E+04 | 30.0 |
| 0.3 | 0.100 | 9.44E+03 | 28.8 |
| 0.6 | 0.100 | 8.26E+03 | 26.9 |
| 0.8 | 0.100 | 6.08E+03 | 26.1 |
| 0.9 | 0.100 | 5.08E+03 | 21.3 |

# FIG. 7

| $Gd_2O_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.45E+04 | 29.2 |
| 0.1 | 0.100 | 1.31E+04 | 30.3 |
| 0.3 | 0.100 | 1.16E+04 | 28.9 |
| 0.6 | 0.100 | 1.02E+04 | 27.0 |
| 0.8 | 0.100 | 7.72E+04 | 25.5 |
| 0.9 | 0.100 | 5.72E+04 | 21.5 |

## FIG. 8

| La(OH)$_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.39E+04 | 28.8 |
| 0.1 | 0.100 | 1.25E+04 | 29.6 |
| 0.3 | 0.100 | 1.11E+04 | 28.2 |
| 0.5 | 0.100 | 9.75E+03 | 27.9 |
| 0.8 | 0.100 | 7.36E+03 | 25.9 |
| 0.9 | 0.100 | 6.36E+03 | 21.8 |

## FIG. 9

| Yb$_2$O$_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 5.44E+03 | 29.5 |
| 0.1 | 0.100 | 4.90E+03 | 29.9 |
| 0.3 | 0.100 | 4.35E+03 | 28.7 |
| 0.6 | 0.100 | 3.81E+03 | 26.9 |
| 0.8 | 0.100 | 3.17E+03 | 25.4 |
| 0.9 | 0.100 | 2.97E+03 | 20.6 |

FIG. *10*

| $Nd_2O_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.24E+04 | 29.4 |
| 0.1 | 0.100 | 1.11E+04 | 30.0 |
| 0.3 | 0.100 | 9.91E+03 | 29.0 |
| 0.7 | 0.100 | 8.67E+03 | 26.9 |
| 0.8 | 0.100 | 7.43E+03 | 26.4 |
| 0.9 | 0.100 | 6.43E+03 | 22.0 |

FIG. *11*

| $Dy_2O_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.14E+04 | 30.8 |
| 0.1 | 0.100 | 1.02E+04 | 31.8 |
| 0.3 | 0.100 | 9.09E+03 | 30.5 |
| 0.8 | 0.100 | 7.96E+03 | 27.2 |
| 0.9 | 0.100 | 6.82E+03 | 23.1 |

FIG. 12

| Ho$_2$O$_3$ content (mass%) | Content in terms of CuO (mass%) | High temperature load life (sec) | Piezoelectric property kr × ( $\varepsilon$ )$^{1/2}$ |
|---|---|---|---|
| 0 | 0.100 | 5.42E+03 | 24.8 |
| 0.05 | 0.100 | 1.25E+04 | 29.3 |
| 0.1 | 0.100 | 1.10E+04 | 30.3 |
| 0.3 | 0.100 | 9.73E+03 | 29.0 |
| 0.8 | 0.100 | 8.43E+03 | 25.8 |
| 0.9 | 0.100 | 7.23E+03 | 22.8 |

FIG. 13

| Tb$_2$O$_3$ content (mass%) | Content in terms of CuO (mass%) | High temperature load life (sec) | Piezoelectric property kr × ( $\varepsilon$ )$^{1/2}$ |
|---|---|---|---|
| 0 | 0.100 | 5.42E+03 | 24.8 |
| 0.05 | 0.100 | 1.19E+04 | 29.7 |
| 0.1 | 0.100 | 1.05E+04 | 30.7 |
| 0.3 | 0.100 | 9.18E+03 | 29.4 |
| 0.8 | 0.100 | 8.04E+03 | 26.2 |
| 0.9 | 0.100 | 7.09E+03 | 23.1 |

## FIG. 14

| Er$_2$O$_3$ content (mass%) | Content in terms of CuO (mass%) | High temperature load life (sec) | Piezoelectric property $kr \times (\varepsilon)^{1/2}$ |
|---|---|---|---|
| 0 | 0.100 | 5.42E+03 | 24.8 |
| 0.05 | 0.100 | 1.27E+04 | 29.2 |
| 0.1 | 0.100 | 1.14E+04 | 30.1 |
| 0.3 | 0.100 | 9.91E+03 | 28.9 |
| 0.8 | 0.100 | 8.59E+03 | 25.7 |
| 0.9 | 0.100 | 7.37E+03 | 22.7 |

## FIG. 15

| Main constituent composition: a | High temperature load life (sec) | Piezoelectric property $kr \times (\varepsilon)^{1/2}$ |
|---|---|---|
| 0.950 | 1.18E+04 | 23.8 |
| 0.960 | 1.13E+04 | 27.0 |
| 0.995 | 1.02E+04 | 31.8 |
| 1.005 | 1.00E+04 | 28.5 |
| 1.030 | 1.00E+04 | 27.5 |
| 1.050 | 9.72E+03 | 22.0 |

## FIG. 16

| Main constituent composition: b | High temperature load life (sec) | Piezoelectric property $kr \times (\varepsilon)^{1/2}$ |
|---|---|---|
| 0.00 | 9.72E+03 | 30.0 |
| 0.01 | 1.00E+04 | 30.6 |
| 0.03 | 1.02E+04 | 31.8 |
| 0.06 | 1.14E+04 | 30.5 |
| 0.10 | 1.20E+04 | 28.5 |
| 0.12 | 1.28E+04 | 22.8 |

## FIG. 17

| Main constituent composition: Me | High temperature load life (sec) | Piezoelectric property $kr \times (\varepsilon)^{1/2}$ |
|---|---|---|
| Ca | 9.92E+03 | 31.7 |
| Ba | 1.07E+04 | 31.5 |

# FIG. 18

| Main constituent composition | | | High temperature load life (sec) | Piezoelectric property $kr \times (\varepsilon)^{1/2}$ |
|---|---|---|---|---|
| x | y | z | | |
| 0 | 0.48 | 0.52 | 1.04E+04 | 20.6 |
| 0.05 | 0.43 | 0.52 | 1.05E+04 | 27.1 |
| 0.05 | 0.50 | 0.45 | 1.03E+04 | 26.9 |
| 0.10 | 0.43 | 0.47 | 1.02E+04 | 31.8 |
| 0.10 | 0.45 | 0.45 | 1.01E+04 | 29.1 |
| 0.10 | 0.50 | 0.40 | 1.04E+04 | 27.6 |
| 0.10 | 0.53 | 0.37 | 1.00E+04 | 15.1 |
| 0.15 | 0.45 | 0.40 | 1.01E+04 | 27.6 |

# FIG. 19

| Additive species | Content (mass%) | High temperature load life (sec) | Piezoelectric property $kr \times (\varepsilon)^{1/2}$ |
|---|---|---|---|
| $Ta_2O_5$ | 0 | 2.76E+02 | 22.5 |
| $Ta_2O_5$ | 0.10 | 1.02E+03 | 30.9 |
| $Ta_2O_5$ | 0.20 | 3.07E+03 | 31.2 |
| $Ta_2O_5$ | 0.40 | 1.02E+04 | 31.5 |
| $Ta_2O_5$ | 0.60 | 4.60E+04 | 30.2 |
| $Ta_2O_5$ | 1.00 | 7.67E+04 | 27.8 |
| $Sb_2O_3$ | 0.10 | 1.53E+03 | 26.3 |
| $Sb_2O_3$ | 0.50 | 3.38E+04 | 26.2 |
| $Nb_2O_3$ | 0.10 | 2.56E+03 | 26.7 |
| $Nb_2O_3$ | 0.50 | 3.89E+04 | 26.6 |
| $WO_3$ | 0.10 | 4.60E+03 | 29.7 |
| $WO_3$ | 0.50 | 4.09E+04 | 31.1 |

FIG. 20

| Form | High temperature load life (sec) | Piezoelectric property $kr \times (\varepsilon)^{1/2}$ |
|---|---|---|
| Laminate | 1.00E+04 | 30.8 |
| Bulk | 1.02E+04 | 31.8 |

FIG. 21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004137106 A